# EUROPEAN PATENT APPLICATION

(11) **EP 4 576 969 A2**
(43) Date of publication of application: **25.06.2025**
(21) Application number: 24212378.4
(22) Date of filing: 12.11.2024
(51) Int. Cl.: H05K 9/00, H05K 1/02

(54) **STRUCTURE FOR REDUCING CROSSTALK INSIDE A SHIELDED DEVICE**

(30) Priority: 22.12.2023 US 202318394154
(71) Applicant: INTEL Corporation, Santa Clara, CA 95054 (US)
(72) Inventor: GLAZER, Lidar, Rishon LeZion (IL); MELHORN, Jesse, Keizer, OR, 97303 (US); PERRY, Richard, Portland, OR (US); ABIRI, Ron, 4334622 Raanana (IL)
(74) Representative: Viering, Jentschura & Partner mbB Patent- und Rechtsanwälte

(57) **Abstract**

A system includes a communication chain (108) to operate in a communication band. The communication chain (108) is mounted on a circuit board. The system includes a connectivity device (102) coupled to the communication chain (108). The system includes a metal shield. (400, 500). The metal shield (400, 500) has a shield perimeter and is disposed over at least a portion of the communication chain (108). The metal shield (400, 500) has at least one formation (502, 504, 506, 508) formed within the shield perimeter for providing a connection between the metal shield (400, 500) and the circuit board.

## Description

### TECHNICAL FIELD

Embodiments described herein generally relate to reducing interference, and in particular to reducing crosstalk within shielded devices.

### BACKGROUND

Electrical circuits often require shielding to reduce emissions from the circuit or to shield the circuit from unwanted interference. However, as semiconductor technologies advance to integrate more functionality, new packaging techniques may be used to accommodate the shrinking die size. Shielding structures should be adjusted to accommodate these new integration and packaging techniques.

### BRIEF DESCRIPTION OF DRAWINGS

FIG. 1 shows a system in which certain aspects of the disclosure may be implemented.
FIG. 2 illustrates aggression by connectors of various generations.
FIG. 3 illustrates another example of interference increasing with generation of connector.
FIG. 4 illustrates use of a shield creating elevated levels of interference.
FIG. 5 illustrates a metal shield having formed therein various pillars according to some aspects of the disclosure.
FIG. 6A illustrates a metal shield having formed therein various walls according to some aspects of the disclosure.
FIG. 6B illustrates a metal shield having formed therein various walls and pillars according to some aspects of the disclosure.
FIG. 7 compares radiation before and after placing pillars or other structures according to some aspects of the disclosure.
FIG. 8 illustrates a method for designing and placing a shield including structures according to some aspects of the disclosure.

### DETAILED DESCRIPTION

Many electrical circuits require shielding to either avoid unwanted emission from the circuit or to protect the circuit from external aggressors that may impact circuit functionality and performance. As such it is a common practice to have a metal shield covering most circuits, especially those that include radio frequency (RF) circuits such as oscillators, receivers, and power transmitters.

However, as modern circuits and system on chip (SoC) structures integrate more functionalities, the shielding structure may create a problem because the structure may amplify certain frequencies. If the interference aggressor is inside the shielded compartment, the aggressor can interfere with other circuits operating at these frequencies, limiting the capabilities that can be integrated together. Furthermore, some available methods, such as providing a conductive sponge over the noise source to create isolation, cannot be used in most modern circuit designs because the amount of space between the shield and circuit components is insufficient to allow addition of a conductive sponge. Systems and apparatuses according to embodiments address these and other concerns by adapting and modifying the shield structure to adjust for circuit layout and other parameters.

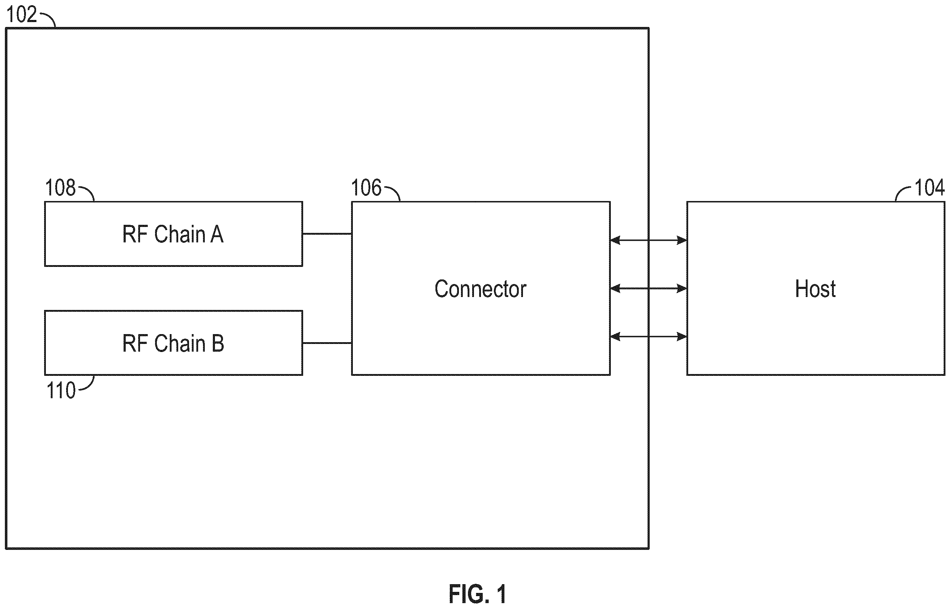

FIG. 1 shows a system in which certain aspects of the disclosure may be implemented. The system includes a wireless connectivity apparatus 102, which is connected to a host 104 through a connector 106. The wireless connectivity apparatus 102 can include one or more communication chains or RF chains, e.g., RF chain 108 and RF chain 110. While two RF chains 108, 110 are shown, the apparatus 102 can include any number of RF chains or other components. In various aspects, the RF chains 108 and 110 can be implemented on a single integrated circuit and, e.g., mounted on a circuit board.

The first RF chain 108 can be configured and/or operated to provide communications over a first carrier frequency or a first frequency range. As an example, the first RF chain 108 can be tuned to a first carrier and/or a first carrier frequency or frequency range. The second RF chain 110 can be configured and/or operated to provide communications over a second carrier frequency or frequency range. As an example, the second RF chain 110 can be tuned to a second carrier and/or a second carrier frequency or frequency range. In some examples, the first RF chain 108 can be configured to operate in one of a Wi-Fi or Bluetooth bands, e.g., in a 2.4-2.5 GHz band or in a 5.15-7.125 GHz band. The second RF chain 110 may be configured to operate in another band than the first RF chain 108, e.g., in a 2.4-2.5 GHz band or in a 5.15-7.125 GHz band. While 2.4-2.5 GHz and 5.15-7.125GHz bands are described, RF chains 108, 110 may operate in other bands.

Data can be transferred from the host 104 to the apparatus 102 using a connector 106. In some examples, the connector 106 includes a Peripheral Component Interconnect Express (PCIe) bus that can support high data rates and various generations (e.g., Gen 4) and versions of WiFi protocols (e.g., Wi-Fi 7). However, aspects of the disclosure are not limited to particular generations, versions or protocols. Instead, the apparatuses and devices, as described herein with respect to aspects of the disclosure, can be modified or designed based on additional or later communication protocols and connector generations.

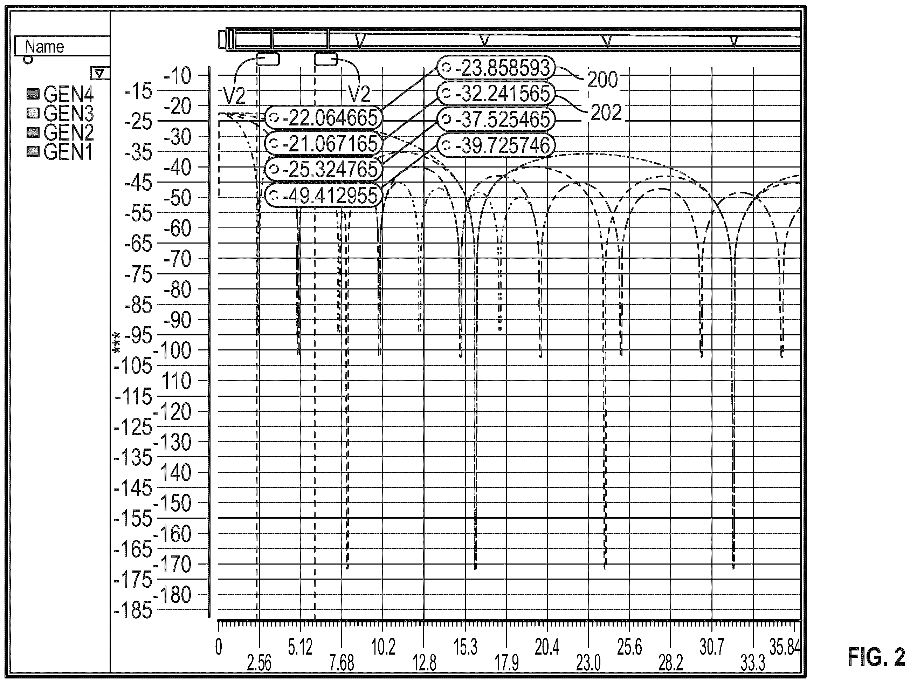

The apparatus 102 can experience interference among components, for example the connector 106 may cause interference (e.g., be an "aggressor"). In examples, higher or later generations of the connector (or other aggressor) can cause higher levels of interference for the "victim" (or RF chains 108, 110 in the example). For example, FIG. 2 illustrates aggression by connectors of various generations. For example, a higher generation shown in curve 200 has a higher energy and can generate interference at a higher level than a curve 202 according to a lower generation of connector. This can be due to the smaller physical dimension of circuits used for higher generation communication bus protocols, leading to proximity of components on apparatus 102. Further, providing a shield over the apparatus 102 (to prevent, e.g., emissions from the apparatus 102 or interference from outside the apparatus 102) can cause the energy to remain inside the apparatus 102 and generate increased interference.

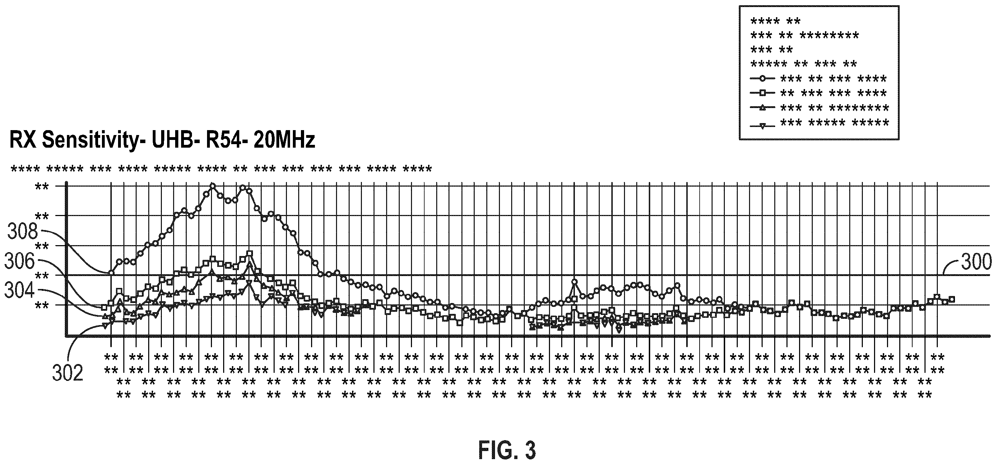

FIG. 3 illustrates another example of interference increasing generated from the communications bus. As seen in FIG. 3, a receiver (e.g., a receiver within RF chain 108, 110 (FIG. 1)) may be desensitized from connector 106 interference. Below limit 300, desensitizing does not occur. Curves 302, 304, and 306 are typically below limit 300 and represent older generations of a connector 106. On the other hand, a newer generation of connector may show interference 308 that is above the desensitizing limit, creating issues for the RF chain 108, 110.

Referring again to FIG. 1, in some examples, the interference levels (and aggression levels) may affect different frequency bands to a greater extent. For example, when the "victim" or RF chain 108, 110 is operating according to WiFi 6E protocols, the frequency band may be extended to cover the 5.15 to 7.125 GHz range, where the RF chain 108, 110 is more susceptible to interfering signals (whether from the connector 106 or other component not shown in FIG. 1). As an additional example, with WiFi 7, new modulation classes are supported that require lower values of error vector magnitude (EVM) across a wider bandwidth (e.g., double bandwidth or other multiple), which further increases the susceptibility to interfering signals.

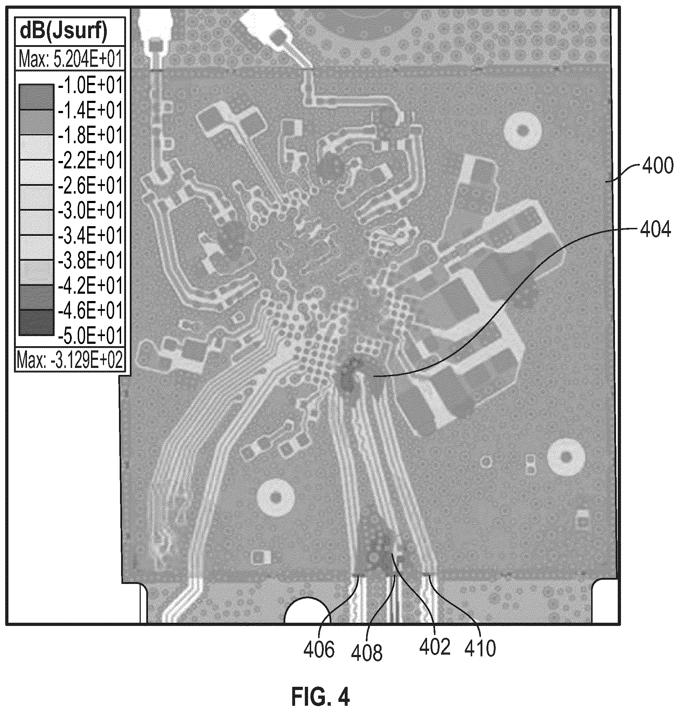

As mentioned above with respect to FIG. 2, previously-available solutions provided a metal shield over various components in an attempt to prevent bidirectional external interference. However, aggressors within the shield could still cause interference within the shield, as is additionally shown in FIG. 4.

FIG. 4 illustrates use of a shield creating elevated levels of interference. In the example, a shield 400 is provided over portions of a circuit (e.g., over portions of apparatus 102 (FIG. 1)). The shield 400 may not let energy dissipate and instead, interference may "bounce" among various components under the shield 400. High levels of interference can be observed at various points 402, 404 (which can vary depending on the type of apparatus, generation, etc.). A connector can be seen at elements 406, 408, 410.

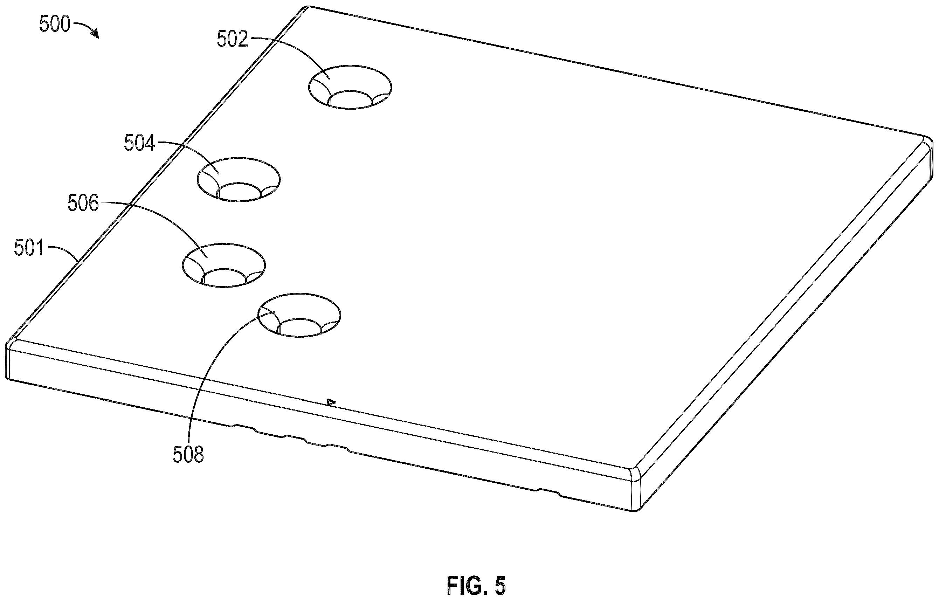

Due to the increasing level of interference on one hand and the susceptibility of the receiver on the other hand, the requirement for isolation between aggressors and victims is more stringent compared to previous generations, so the designs described above (e.g., with respect to FIG. 4) fail to meet current and future product requirements. Apparatuses according to aspects of the disclosure address these and other concerns by providing modifications to the metal shield as shown in FIG. 5.

FIG. 5 illustrates a metal shield 500 having formed therein various formations or pillars 502, 504, 506, 508. Pillars 502, 504, 506, 508 can be formed by, for example "punching" into the metal shield during manufacturing or design of the metal shield 500, and grounding the pillars 502, 504, 506, 508 to ground pads or other grounding elements by for example soldering. In examples, the metal shield 500 can have a shield perimeter 501 and the metal shield 500 can be disposed over at least a portion of a communication chain similarly to the mounting of shield 400 (FIG. 4). A solder mask can be cleared below the pillars 502, 504, 506, 508 to enable soldering. Ground vias can be provided below or alongside the pillars 502, 504, 506, 508. Pillars 502, 504, 506, 508 can be fully closed, e.g., there may be no opening at the bottom of pillars 502, 504, 506, 508. Pillars 502, 504, 506, 508 should be placed deep enough to contact or touch the circuit board (e.g., printed circuit board (PCB)) beneath. The sides of the pillars can be comprised of the same or similar metal as that of the shield 500.

The optimization of the location of the punches is done by investigating the level of isolation degradation and location over frequency. The number and location of the punches (and by extension the location of pillars 502, 504, 506, 508) can be selected to yield the highest isolation at highest frequency as possible to, e.g., move interference outside the WiFi band or any other band as used or implemented in RF chain 108, 110 (FIG. 1). With this punched shield 500, degradation can be moved to higher frequencies (or to different frequencies depending on the different communication bands used in other example devices) and the degradation level was reduced below threshold of interference. The location, number and distribution of pillars can also be adjusted for other communication protocols or to reduce or eliminate interference to other types of components.

The shield can be designed based on the resonance of the shield, for example smaller shields may resonate at higher frequencies. The shield should be made to appear smaller from a radiation perspective by, for example, providing punched pillars (e.g., pillars 502, 504, 506, 508) that effectively changes the resonance to be higher values. The grounding of the pillars 502, 504, 506, 508 (to the PCB board or elsewhere such as ground pads located beneath pillars 502, 504, 506, 508) change the shield 500 resonance so that the shield appears smaller, and the pillar placement can also change how interference signals move (e.g., "bounce") under the shield 500.

Manufacturing costs can also be reduced because the shield materials are selected to be made of softer metals (e.g., annealed steel or other softer steel) that can be bent to form pillars where needed. A progressive die is manufactured wherein a flat piece of metal is provided and then pushed, impressed, deformed, or "punched," where needed to form pillars 502, 504, 506, 508. Welding costs can be reduced or eliminated.

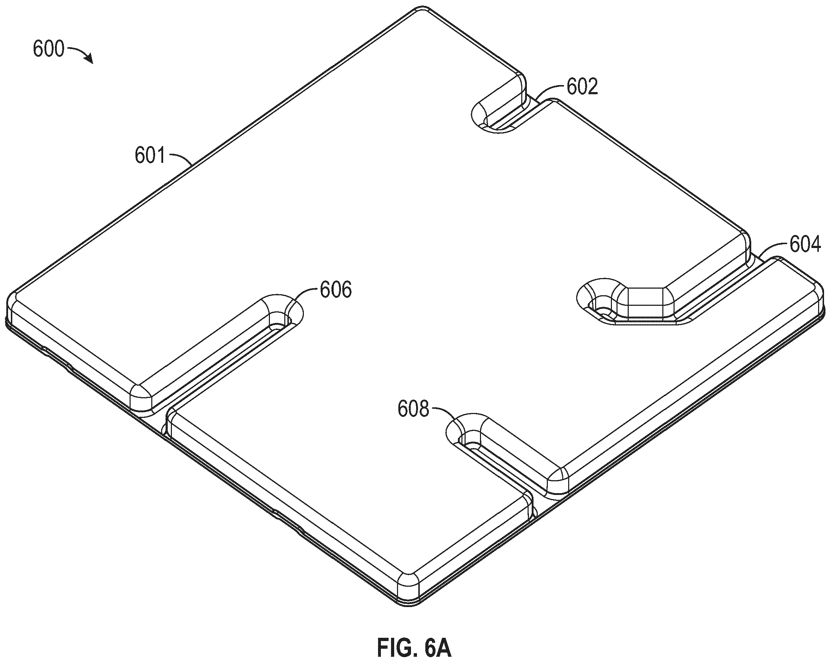

In addition to or instead of forming pillars as shown in FIG. 5, compartments can be created within the shield to separate components, providing further or alternative isolation. FIG. 6A illustrates a metal shield 600 having formed therein various walls 602, 604, 606, 608, that can be formed by, for example "punching" into the metal shield during manufacturing or design of the metal shield 600, and grounding the walls 602, 604, 606, 608 to ground pads or other grounding elements. as seen in FIG. 6A. In examples, the walls can extend from the shield perimeter 601 and inward, although embodiments are not limited thereto. Shapes and sizes of the walls 602, 604, 606, 608 can also be adjusted.

The walls 602, 604, 606, 608 can be placed to isolate other components of an RF front end or any circuit component, such as traces, crystals, filters, antennas, etc. Any transmitting elements within the shield 600 can be isolated, or signals from outside the shield 600 can be prevented from entering at various points in the apparatus 102 (FIG. 1).

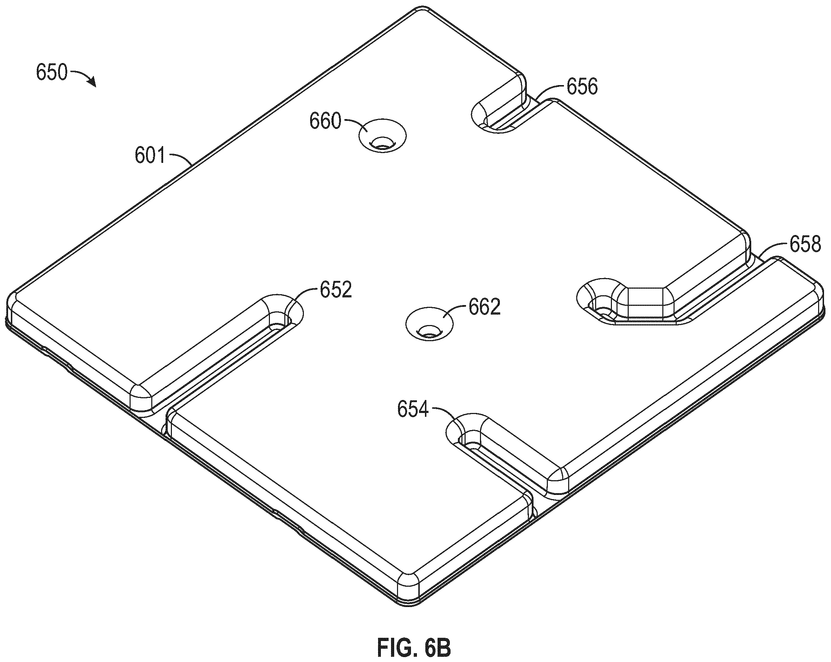

Walls 602, 604, 606, 608 can be combined with pillars of FIG. 5 in any configuration or combination, and in any size or shape. FIG. 6B illustrates a metal shield 650 having formed therein various walls 652, 654, 656, 658 and pillars 660, 662 that can be similarly formed by, for example "punching" into the metal shield during manufacturing or design of the metal shield 600, and grounding the walls 602, 604, 606, 608 to ground pads or other grounding elements. as seen in FIG. 6B. Shapes and sizes of the walls 602, 604, 606, 608 can also be adjusted.

The walls 602, 604, 606, 608 can be placed to isolate other components of an RF front end or any circuit component, such as crystals, filters, antennas, etc. Any transmitting elements within the shield 600 can be isolated, or signals from outside the shield 600 can be prevented form entering at various points in the apparatus 102 (FIG. 1). Walls 602, 604, 606, 608 can be combined with pillars of FIG. 5 in any configuration or combination, and in any size or shape.

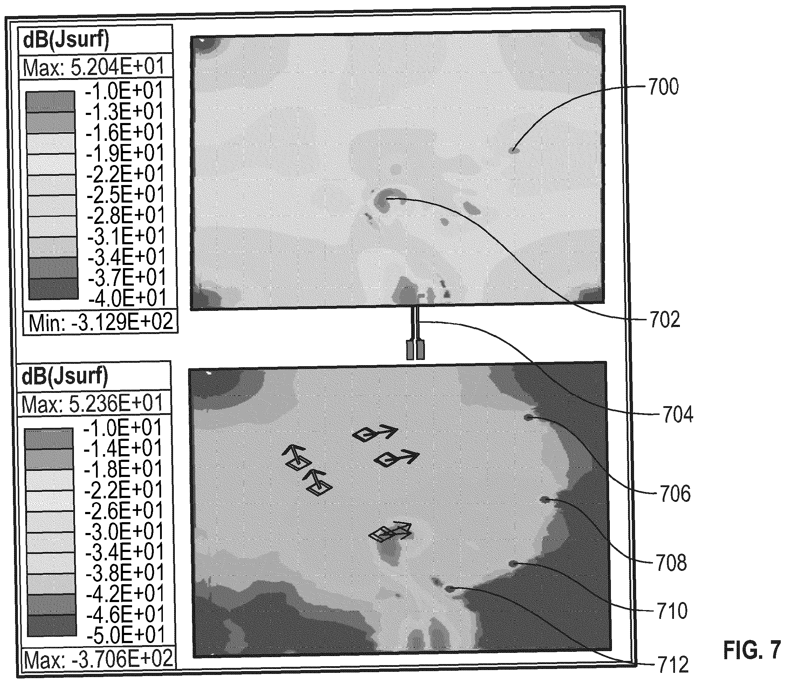

FIG. 7 compares radiation before and after placing pillars or other structures according to some aspects of the disclosure. In the top half of the figure, spots 700 and 702 indicate portions that may receive excessive interference at a certain operating frequency (e.g., on the order of about 7 GHz), and can include for example, components of a modem for WiFi products, antennas, or other components subject to interference. Component 704 illustrates a connector for example a PCIe cable or other connection. Spot 700 for example is subject to relatively high-surface current density area potentially causing interference or high-energy interference, where J_{surf} is the surface current density in units of amperes per meter squared (A/m²). After placement of pillars 706, 708, 710, 712, J_{surf} is reduced to lower levels as shown in the lower half of FIG. 7.

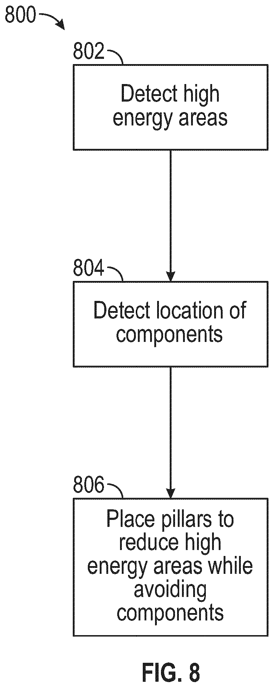

FIG. 8 shows a method 800 for providing an interference mitigation shield according to some aspects. The method 800 can begin with operation 802 with detecting high energy areas in a circuit. For example, a simulation tool can determine current density or location of hot spots at the inside surface of a shield (e.g., shield 400 (FIG. 4)).

The method 800 can continue with operation 804 with detecting location of other components of the circuit or device below the shield. Operation 804 can be included in a design or layout process or information can be retrieved from the design process to determine location of components.

The method 800 can continue with operation 806 with placing pillars in various shapes or other structures (e.g., walls) as shown at FIG. 5 and FIG. 6A-6B to reduce that will reduce the number, degree or size of hot spots while avoiding components on the board. Pillars or walls can be placed by punching properly sized or shaped holes into a shielding structure to create vertical metallic pillars or walls. The existence, number and location of such metallic pillars, can shift the resonant frequency of the cavity outside of the 5-7.1 GHz band of WiFi or outside any other communication band or operating frequency of circuits or components of circuits under the shield.

Any of the components or methods described above with reference to FIG. 1 through FIG. 8 can be implemented in a number of ways, including simulation via software. Thus, apparatuses may all be characterized as "modules" (or "module") herein. Such modules may include hardware circuitry, single- and/or multi-processor circuits, memory circuits, software program modules and objects and/or firmware, and combinations thereof, as desired and/or as appropriate for particular implementations of various embodiments. For example, such modules may be included in a system operation simulation package, such as a software electrical signal simulation package, a power usage and ranges simulation package, a capacitance-inductance simulation package, a power/heat dissipation simulation package, a signal transmission-reception simulation package, and/or a combination of software and hardware used to operate or simulate the operation of various potential embodiments. Modules can include computer-readable media including operations for implementing any simulations or methods described herein.

The apparatuses and methods described above can include or be included in high-speed computers, communication and signal processing circuitry, single- or multi-processor modules, single or multiple embedded processors, multicore processors, message information switches, and application-specific modules including multilayer, multichip modules. Such apparatuses may further be included as subcomponents within a variety of other apparatuses (e.g., electronic systems), such as televisions, cellular telephones, personal computers (e.g., laptop computers, desktop computers, handheld computers, tablet computers, etc.), workstations, radios, video players, audio players (e.g., MP3 (Motion Picture Experts Group, Audio Layer 3) players), vehicles, medical devices (e.g., heart monitor, blood pressure monitor, etc.), set top boxes, and others.

In the detailed description and the claims, the terms "first," "second," and "third," etc. are used merely as labels, and are not intended to impose numerical requirements on their objects.

In the detailed description and the claims, the term "on" used with respect to two or more elements (e.g., materials), one "on" the other, means at least some contact between the elements (e.g., between the materials). The term "over" means the elements (e.g., materials) are in close proximity, but possibly with one or more additional intervening elements (e.g., materials) such that contact is possible but not required. Neither "on" nor "over" implies any directionality as used herein unless stated as such.

In the detailed description and the claims, the term "adjacent" generally refers to a position of a thing being next to (e.g., either immediately next to or close to with one or more things between them) or adjoining another thing (e.g., abutting it or contacting it (e.g., directly coupled to) it).

In the detailed description and the claims, a list of items joined by the term "at least one of' can mean any combination of the listed items. For example, if items A and B are listed, then the phrase "at least one of A and B" means A only; B only; or A and B. In another example, if items A, B, and C are listed, then the phrase "at least one of A, B and C" means A only; B only; C only; A and B (excluding C); A and C (excluding B); B and C (excluding A); or all of A, B, and C. Item A can include a single element or multiple elements. Item B can include a single element or multiple elements. Item C can include a single element or multiple elements.

In the detailed description and the claims, a list of items joined by the term "one of' can mean only one of the list items. For example, if items A and B are listed, then the phrase "one of A and B" means A only (excluding B), or B only (excluding A). In another example, if items A, B, and C are listed, then the phrase "one of A, B and C" means A only; B only; or C only. Item A can include a single element or multiple elements. Item B can include a single element or multiple elements. Item C can include a single element or multiple elements.

Described implementations of the subject matter can include one or more features, alone or in combination as illustrated below by way of examples.

Example 1 is a system comprising: a communication chain configured to operate in a communication band, the communication chain mounted on a circuit board; a connectivity device coupled to the communication chain; and a metal shield, having a shield perimeter and disposed over at least a portion of the communication chain, and the metal shield having at least one formation formed within the shield perimeter for providing a connection between the metal shield and the circuit board.

In Example 2, the subject matter of Example 1 can optionally include wherein the at least one formation includes a pillar formed by deforming a surface of the metal shield to provide a closed pillar having sides formed of a same metal as the metal shield.

In Example 3, the subject matter of any one of Examples 1-2 can optionally include wherein the at least one formation is grounded to the circuit board.

In Example 4, the subject matter of any one of Examples 1-3 can optionally include wherein the at least one formation is grounded to the circuit board proximate a communication component of the communication chain.

In Example 5, the subject matter of any one of examples 1-4 can optionally include wherein a plurality of formations formed within the shield perimeter.

In Example 6, the subject matter of Example 5 can optionally include wherein at least one of the plurality of formations comprises a pillar and at least another of the plurality of formations comprises a wall extending from the shield perimeter and inward.

In Example 7, the subject matter of any of Examples 1-6 can optionally include wherein the connectivity device includes a Peripheral Component Interconnect bus.

In Example 8, the subject matter of any of Examples 1-7 can optionally include wherein the at least one formation changes a resonant frequency within the metal shield to be outside the communication band of the communication chain.

In Example 9, the subject matter of any of Examples 1-8 can optionally include wherein the communication chain is configured to operate in one of a WiFi and a Bluetooth frequency band.

In Example 10 the subject matter of any of Examples 1-9 can optionally include a second communication chain to operate in a different communication band than the communication chain.

Example 11 is a method for providing an interference mitigation shield, the method comprising: operating a communication circuit within a metal shield to detect high energy areas on the communication circuit; accessing location information for components of the communication circuit; and providing structures within the metal shield such that high energy areas are reduced or eliminated.

In Example 12, the subject matter of Example 11 can optionally include wherein the structures are provided by impressing or deforming a metal shield to provide grounding locations between the metal shield and a circuit board upon which the communication circuit is disposed.

In Example 13, the subject matter of any of Examples 11-12 can optionally include wherein the communication circuit is operated with a metal shield disposed over the communication circuit and wherein energy readings are captured from a surface of the metal shield over the communication circuit.

In Example 14, the subject matter of Example 13 can optionally include wherein the structures are provided at locations selected to change frequency of interference signals outside communication bands of the communication circuit.

Example 15 is an apparatus comprising: a circuit board having components mounted on a surface of the circuit board; a metal shield, having a shield perimeter and disposed over at least a portion of the components; and the metal shield having at least one formation formed within the shield perimeter for providing a connection between the metal shield and the circuit board.

In Example 16, the subject matter of Example 15 can optionally include wherein the at least one formation includes a pillar formed by deforming a surface of the metal shield to provide a closed pillar having sides formed of a same metal as the metal shield.

In Example 17, the subject matter of any of Examples 15-16 can optionally include wherein the at least one formation is grounded to the circuit board.

In Example 18, the subject matter of any of Examples 15-17 can optionally include wherein the at least one formation is grounded to the circuit board proximate a communication component.

In Example 19, the subject matter of any of Examples 15-18 can optionally include wherein a plurality of formations formed within the shield perimeter.

In Example 20, the subject matter of Example 19 can optionally include wherein at least one of the plurality of formations comprises a pillar and at least another of the plurality of formations comprises a wall extending from the shield perimeter and inward.

Example 21 is a system comprising means for performing any of Examples 11-14.

Example 22 is a computer readable medium including software for performing any of Examples 11-14.

The above description and the drawings illustrate some embodiments of the inventive subject matter to enable those skilled in the art to practice the embodiments of the inventive subject matter. Other embodiments may incorporate structural, logical, electrical, process, and other changes. Examples merely typify possible variations. Portions and features of some embodiments may be included in, or substituted for, those of others. Many other embodiments will be apparent to those of skill in the art upon reading and understanding the above description.

The Abstract is provided to allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

## Claims

1. A system comprising:
a communication chain configured to operate in a communication band, the communication chain mounted on a circuit board;
a connectivity device coupled to the communication chain; and
a metal shield, having a shield perimeter and disposed over at least a portion of the communication chain, and the metal shield having at least one formation formed within the shield perimeter for providing a connection between the metal shield and the circuit board.

2. The system of claim 1, wherein the at least one formation includes a pillar formed by deforming a surface of the metal shield to provide a closed pillar having sides formed of a same metal as the metal shield.

3. The system of any one of claims 1 or 2, wherein the at least one formation is grounded to the circuit board proximate to a communication component of the communication chain.

4. The system of any one of claims 1 to 3, wherein a plurality of formations are formed within the shield perimeter, and wherein at least one of the plurality of formations comprises a pillar and at least another of the plurality of formations comprises a wall extending from the shield perimeter and inward.

5. The system of any one of claims 1 to 4, wherein the connectivity device includes a Peripheral Component Interconnect (PCI) bus.

6. The system of any one of claims 1 to 5, wherein the at least one formation changes a resonant frequency within the metal shield to be outside the communication band of the communication chain.

7. The system of any one of claims 1 to 6, wherein the communication chain is configured to operate in one of a Wi-Fi and a Bluetooth frequency band.

8. The system of any one of claims 1 to 7, further comprising:
a second communication chain to operate in a different communication band than the communication chain.

9. A method for providing an interference mitigation shield, the method comprising:
operating a communication circuit within a metal shield to detect high-energy areas on the communication circuit;
accessing location information for components of the communication circuit; and
providing structures within the metal shield such that high-energy areas are reduced or eliminated.

10. The method of claim 9, wherein the structures are provided by impressing or deforming a metal shield to provide grounding locations between the metal shield and a circuit board upon which the communication circuit is disposed.

11. The method of any one of claims 9 or 10, wherein the communication circuit is operated with a metal shield disposed over the communication circuit and wherein energy readings are captured from a surface of the metal shield over the communication circuit.

12. The method of any one of claims 9 to 11, wherein the structures are provided at locations selected to change frequency of interference signals outside communication bands of the communication circuit.

13. Machine-readable storage, including machine-readable instructions, which when executed, cause a device to implement a method as claimed in any one of claims 9 to 12.

14. A computer program comprising instructions which, when the program is executed by a computer, cause the computer to carry out the method as claimed in any one of claims 9 to 12.
